# EUROPÄISCHE PATENTSCHRIFT

(11) **EP 0 824 429 B1**
(45) Veröffentlichungstag und Bekanntmachung des Hinweises auf die Patenterteilung: **28.07.1999**
(21) Anmeldenummer: 96910956.0
(22) Anmeldetag: 06.04.1996
(51) Int. Cl.: B60T 8/36

(54) **HYDRAULISCHE KRAFTFAHRZEUGBREMSANLAGE MIT BREMSSCHLUPFREGELUNG UND/ODER AUTOMATISCHEM BREMSENEINGRIFF ZUR ANTRIEBS- UND/ODER FAHRDYNAMIKREGELUNG**
HYDRAULIC MOTOR-VEHICLE BRAKE SYSTEM WITH ANTI-LOCKING CONTROL AND AUTOMATIC ACTUATION OF THE BRAKES FOR THE CONTROL OF THE DRIVE AND/OR TRAVEL DYNAMICS
DISPOSITIF DE FREINAGE HYDRAULIQUE POUR VEHICULE A MOTEUR, A SYSTEME ANTIBLOCAGE ET/OU ACTIONNEMENT AUTOMATIQUE DES FREINS POUR LA REGULATION DE LA DYNAMIQUE D'ENTRAINEMENT ET/OU DE ROULEMENT

(30) Priorität: 19.04.1995 DE 19514383
(43) Veröffentlichungstag der Anmeldung: 25.02.1998
(73) Patentinhaber: Continental Teves AG & Co. oHG, 60488 Frankfurt (DE)
(72) Erfinder: HINZ, Axel, D-61267 Neu-Anspach (DE); CZARNETZKI, Edwin, D-65604 Elz (DE)
(86) Internationale Anmeldenummer: EP9601500
(87) Internationale Veröffentlichungsnummer: WO9633081

(56) Entgegenhaltungen:
- EP-A- 0 157 944
- EP-A- 0 411 826
- WO-A-88/03491
- DE-A- 4 221 988
- DE-A- 4 226 646
- DE-A- 4 320 391
- GB-A- 2 249 874

## Beschreibung

Die Erfindung betrifft eine hydraulische Kraftfahrzeugbremsanlage mit Bremsschlupfregelung und/oder automatischem Bremseneingriff zur Antriebs- und/oder Fahrdynamikregelung, nach dem Oberbegriff des Patentanspruchs 1.

Aus der DE 42 32 311 C1 ist bereits eine hydraulische Kraftfahrzeugbremsanlage mit einer Blockierschutzeinrichtung hervorgegangen, die überdies zur Verbesserung des Fahrzeugspurverhaltens mit einem automatischen Bremseneingriff zur Fahrdynamikregelung versehen ist. Sowohl zur Fahrdynamikregelung als auch zur Antriebsschlupfregelung bedarf es besonderer Maßnahmen, um hinreichend schnell das für den Bremseneingriff nötige Druckmittel mittels einer Pumpe bereitzustellen. Hierzu gehört unter anderem die Anordnung eines Drucksensors an dem vom Bremsdruckgeber kommenden Druckmittelpfad, um den vom Fahrer im Bremsdruckgeber jeweils erzeugten Vordruck zu erfassen.

Eine konstruktive Ausführungsvariante zur Anordnung des Drucksensors an einer speziellen Vorladeeinrichtung ist in der Zeitschrift ATZ, 96. Jahrgang/Nr. 11 auf Seite 687 gezeigt. Durch die Anordnung des Drucksensors am Gehäuse der sogenannten Ladekolbeneinheit bedarf es in der Regel einer aufwendigen Verkabelung mit der Steuer- und Regelelektronik.

Aus der gattungsbildenden DE 43 20 391 A1 ist bereits eine hydraulische Kraftfahrzeugbremsanlage mit einer Einrichtung zur Regelung des Bremsschlupfes und des Antriebsschlupfes bekannt, bei der zur Verkleinerung des Ventilblocks ein Druckschalter zur Erkennung einer pedalbetätigten Bremsung aus dem Ventilblock ausgegliedert ist. Der Druckschalter wird von einem hydraulisch vom Hauptzylinderdruck betätigten, drucklos offenen Umschaltventil geschaltet, welches eine Saugleitung bei einer pedalbetätigten Bremsung sperrt.

Daher ist es die Aufgabe der Erfindung, eine hydraulische Kraftfahrzeugbremsanlage mit Bremsschlupfregelung und/oder automatischem Bremseneingriff zur Antriebs- und/oder Fahrdynamikregelung gemäß dem Oberbegriff des Anspruchs 1 derart zu gestalten, daß mit relativ geringem konstruktivem Aufwand der Drucksensor gegenüber äußeren Einflüssen geschützt zu montieren und elektrisch funktionssicher mit der Steuer- und Regelelektronik zu verbinden ist, wobei eine weitgehende Trennung des Hydraulikteils gegenüber dem elektrischen oder elektronischen Teil gewährleistet sein soll.

Diese Aufgabe wird erfindungsgemäß für eine hydraulische Kraftfahrzeugbremsanlage der angegebenen Art mit den kennzeichnenden Merkmalen des Patentanspruchs 1 gelöst.

Weitere Merkmale und zweckmäßige Ausgestaltungsvarianten der Erfindung gehen aus den Unteransprüchen hervor, die anhand mehrerer Zeichnungen nachfolgend erläutert werden.

Es zeigen:
- Fig. 1: einen Querschnitt des Drucksensors,
- Fig. 2: eine Draufsicht auf das Gehäuse für die Druckmodulationsventile,
- Fig. 3: die Innenansicht eines Deckels für das in Fig. 2 dargestellte Gehäuse.

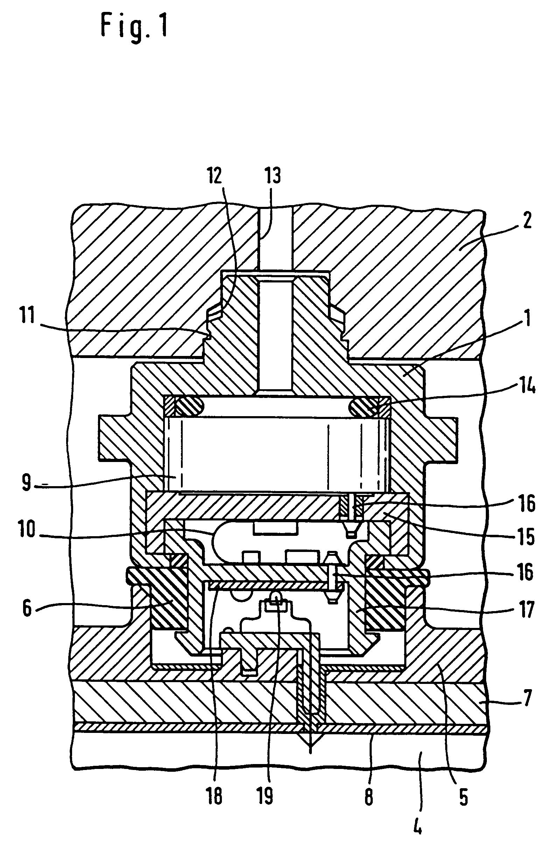

Die Fig. 1 zeigt in nicht maßstäblicher Darstellung eine bevorzugte Ausführungsform für einen Drucksensor 1 gemäß der beanspruchten Erfindung. Der Drucksensor 1 ist mittels einer Selbstverstemmung 11 mit seinem abgestuften Gehäuse in eine Stufenbohrung 12 des die Druckmodulationsventile 3 aufnehmenden Gehäuses 2 befestigt. Der Ausschnitt des Gehäuses 2 verdeutlicht einen Abzweig des Druckmittelpfades 13, der eine Verbindung zwischen einem in der Abbildung nicht gezeigten Bremsdruckgeber und den Druckmodulationsventilen 3 herstellt. Der Drucksensor 1 weist einen Meßelementenraum auf, in dem ein vorzugsweise kapazitiver Meßwertaufnehmer 9 angeordnet ist. Zwischen dem Gehäuse des Drucksensors 1 und dem kapazitiven Meßwertaufnehmer 9 befindet sich eine Ringdichtung 14, die ein Austritt von Druckflüssigkeit des Druckmittelpfades 13 verhindert. Von der hydraulisch beaufschlagten Stirnflache des Meßaufnehmers 9 abgewandt, befindet sich eine Stützplatte 15, welche die vom Fluid auf den Meßaufnehmer 9 wirkenden Druckkraft aufnimmt. Kontaktstifte 16 am Meßwertaufnehmer 9 erstrecken sich durch die Stützplatte 15 bis in einen weiteren Hohlraum des Drucksensors 1, in dem elektrische oder elektronische Bauteile 10 für den Drucksensor 1 angeordnet sind. Die elektronischen Bauteile 10 des Drucksensors 1 können auch auf dem Bauteil 8 angeordnet werden. Dieser Hohlraum für die elektronischen Bauteile 10 ist von einem Steckergehäuse 17 verschlossen, das an seiner Außenseite Leiterbahnen 18 aufweist, die über Kontaktstifte 16 sowohl mit den elektrischen bzw. elektronischen Bauteilen 10 im Hohlraum als auch mit einem ortsfest im Deckel 4 angeordneten Kontakt 19 in Verbindung stehen. Der Deckel 4 weist eine Trägerplatte 7 auf, auf der gleichfalls elektrische bzw. elektronische Bauteile 8 angeordnet sind. Im vorliegenden Beispiel besteht das elektrische Bauteil 8 aus einer Leiterplatte (Platine), die mit den in der Trägerplatte 7 eingebetteten Kontaktstiften der Kontakte 19 verlötet ist. Die Kontaktstifte sind vorzugsweise in den Bohrungen der Trägerplatte 7 mit einer Kunststoffmasse vergossen. Die Kontakte 19 sind nicht unmittelbar auf der Trägerplatte 7 befestigt, sondern in einem vorzugsweise aus einem Kunststoff-Spritzgußteil hergestellten Steckverbinder 5 fixiert, der als Bestandteil des Deckels 4 mit seiner topfförmigen Ausnehmung auf das Steckergehäuse 17 des Drucksensors 1 aufgeschoben ist. Zur Abdichtung der topfförmigen Öffnung zwischen Steckergehäuse 17 und Steckverbinder 5 ist vorzugsweise eine Profildichtung 6 angeordnet, die in vorliegender Abbildung als vormontiertes Teil auf dem Hals des Steckergehäuses 17 gehalten ist und unter Wirkung der Anpreßkraft des Deckels 4 auf den Drucksensor 1 dichtet. Bis auf Ausnahme der elektrischen bzw. elektronischen Bauteile??, 10 und der Kontakte 19 bzw. der Kontaktstifte 16 sind alle weiteren, vorbeschriebenem Elemente rotationssymmetrisch, in ihrer Anordnung und Konstruktion ausgeführt. Alternativ zur abbildungsgemäßen Darstellung der Erfindung kann die Profildichtung 6 durch den Steckverbinder 5 eingefaßt werden.

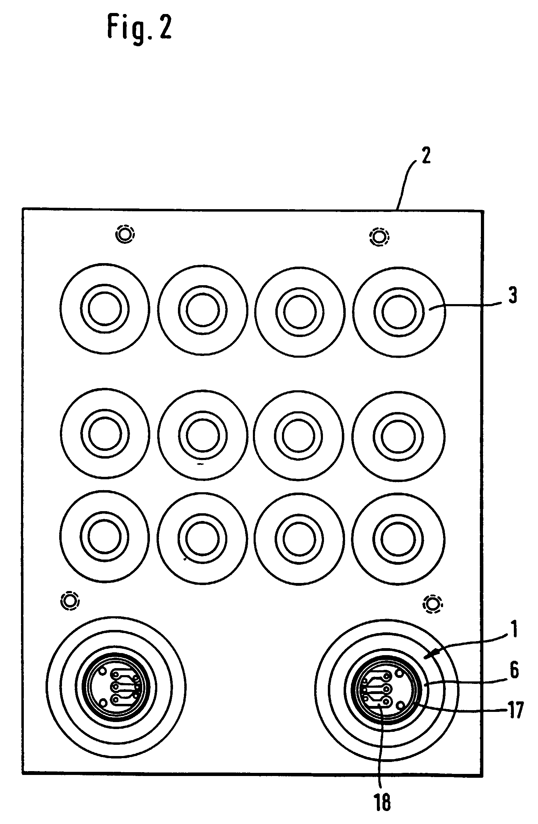

Die Fig. 2 zeigt eine Draufsicht auf das Ventilgehäuse 2 in der Gesamtansicht, welches in mehreren parallelen Reihen die Druckmodulationsventile 3 und den in Fig. 1 dargestellten Drucksensor 1 in doppelter Ausführung in einer Ebene aufweist. Das Gehäuse 2 ist vorzugsweise aus einem weicheren Werkstoff gefertigt als die Gehäuse des Drucksensors 1 und der Druckmodulationsventile 3, so daß vorbeschriebene Drucksensoren 1 und Druckmodulationsventile 3 mittels einer Selbstverstemmung 11 in möglichst einfacher Fertigung in das vorzugsweise aus Leichtmetall bestehende Gehäuse 2 in einem gemeinsamen Arbeitsgang eingepreßt werden können. Das Gehäuse 2 weist hierzu ein symmetrisches Bohrmuster für die Stufenbohrungen 12 auf, wobei der Abstand zwischen 2 Ventilreihen so gewählt ist, daß zwischen den betreffenden Ventilreiher Zwischenraum für die Radialkolben einer Pumpe verbleibt. Ferner geht aus Fig. 2 hervor, daß die seitlich versetzt zu den Ventilreihen gleichachsig angeordneten Drucksensoren 1 jeweils 3 Kontaktstellen auf den als Platine ausgelegten Leiterbahnen 18 aufweisen.

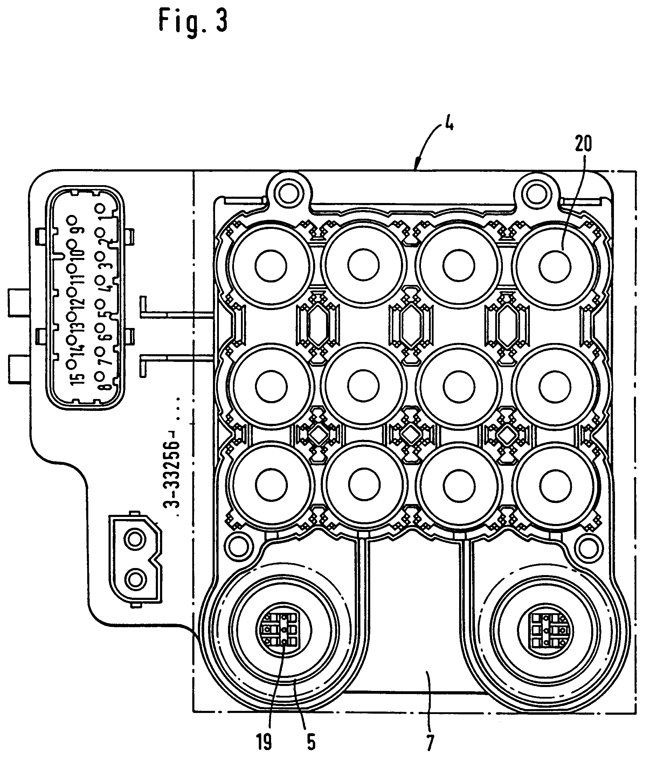

Die mit der aus Fig. 2 ersichtlichen Konfiguration der Einzelelemente zusammenwirkende Steckerkonfiguration geht aus Fig. 3 hervor. Die Fig. 3 zeigt den im wesentlichen an die Blockform des Gehäuses 2 angepaßten Deckel 4, der im einzelnen die Spulen 20 für die Druckmodulationsventile 3 aufnimmt und für jeden Drucksensor 1 den aus Fig. 1 bekannten Steckverbinder 5 beinhaltet. In der Draufsicht von Fig. 3 sind überdies im Steckverbinder 5 die mit den Kontakten des Drucksensors 1 zusammenwirkenden Kontakte 19 zu erkennen. Die aus Fig. 1 bekannte Profildichtung 6 ist in Ringform in Fig. 2 auf dem Steckergehäuse 17 angeordnet, so daß in Fig. 3 ausschließlich die dünnwandigen Stege des topfförmig ausgebildeten Deckels 4 zu erkennen sind. Der Deckel 4 ist aus einem homogenen Kunststoffteil als Rahmen gespritzt, an dem gleichfalls die Spulen 20 befestigt sind. Damit ergibt sich eine weitgehende geschlossene, kompakte Einheit des Deckels 4 in dem alle elektrischen Verbindungen für die Drucksensoren 1 und die Spulen 20 nach Maßgabe in Fig. 1 integriert sind. Als elektrische Verbindungen eignen sich hierzu besonders Kontaktstifte und Leiterbahnen im Sinne einer Platinenanordnung, die vorzugsweise In den Steckverbindern 5 bzw. an der Trägerplatte 7 mit Kunststoff vergossen sind.

Hieraus resultiert eine automatengerechte Fertigung, wodurch sich der Herstellungsprozeß auf ein Minimum an Arbeitsschritten reduziert. Kabelmontagen und separate Kabelverbindungen entfallen, so daß sich eine weitgehend zentrale Steckverbindung am Deckel 4 ergibt, über die alle Spulen 20 und Drucksensoren 1 feuchte- und kurzschlußgeschützt kontaktiert sind. Hierdurch ergibt sich eine weitgehende Trennung des Hydraulikteils nach Fig. 2 gegenüber dem elektrischen bzw. elektronischen Teil nach Fig. 3, so daß separate Diagnose- und Montagemöglichkeiten geschaffen sind. Mit dem Aufsetzen des Dekkels 4 auf das blockförmige Gehäuse 2, an dem die Ventildome der Druckmodulationsventile 3 und die Steckergehäuse 17 der Drucksensoren 1 überstehen, ergibt sich eine relativ einfache Selbstzentrierung der elastisch im Deckel 4 aufgehängten Spulen 20, so daß auch die Steckergehäuse 17 der Drucksensoren 1 in den topfförmig ausgebildeten Deckel gelangen und vorzugsweise von federkraftbeaufschlagten Kontakten 19 auf die Kontaktstellen der Leiterbahnen 18 angepreßt werden.

### Bezugszeichenliste

- 1: Drucksensor
- 2: Gehäuse
- 3: Druckmodulationsventile
- 4: Deckel
- 5: Steckverbinder
- 6: Profildichtung
- 7: Trägerplatte
- 8: Bauteil
- 9: Meßwertaufnehmer
- 10: Bauteil
- 11: Selbstverstemmung
- 12: Stufenbohrung
- 13: Druckmittelpfad
- 14: Ringdichtung
- 15: Stützplatte
- 16: Kontaktstift
- 17: Steckergehäuse
- 18: Leiterbahn
- 19: Kontakt
- 20: Spule

## Patentansprüche

1. Hydraulische Kraftfahrzeugbremsanlage mit Bremsschlupfregelung und automatischem Bremseneingriff zur Antriebs- und/oder Fahrdynamikregelung, mit einem Bremsdruckgeber, der über Druckmodulationsventile (3) mit wenigstens einer Radbremse und einem Druckmittelspeicher hydraulisch verbindbar ist, mit wenigstens einer Pumpe, die mit ihrer Saugseite an den Druckmittelspeicher und mit ihrer Druckseite mit einem vom Bremsdruckgeber zur Radbremse führenden Druckmittelpfad in Verbindung steht, der die Druckmodulationsventile (3) und einen zwischen dem Bremsdruckgeber und den Druckmodulationsventilen am Druckmittelpfad angeschlossenen Drucksensor (1) aufweist, wobei der Drucksensor (1) in einem Gehäuse (2) angeordnet ist, das die Druckmodulationsventile (3) aufnimmt, **dadurch gekennzeichnet**, daß am Gehäuse (2) ein Deckel (4) befestigt ist, der auf den Druckmodulationsventilen (3) und dem Drucksensor (1) angeordnet ist, und daß im Deckel (4) eine Trägerplatte (7) zur Aufnahme von elektrischen und/oder elektronischen Bauteilen (8) vorgesehen ist, die über eine elektrische Steckverbindung eine Verbindung zum Drucksensor (1) herstellt.

2. Hydraulische Kraftfahrzeugbremsanlage nach Anspruch 1, **dadurch gekennzeichnet**, daß zwischen dem Deckel (4) und dem Drucksensor (1) ein Steckverbinder (5) angebracht ist.

3. Hydraulische Kraftfahrzeugbremsanlage nach Anspruch 2, **dadurch gekennzeichnet**, daß zwischen dem Steckverbinder (5) und dem Drucksensor (1) eine Profildichtung (6) vorgesehen ist.

4. Hydraulische Kraftfahrzeugbremsanlage nach einem der vorhergehenden Ansprüche, **dadurch gekennzeichnet**, daß der Drucksensor (1) in einem Sensorgehäuse einen vorzugsweise kapazitiven Meßwertaufnehmer (9) aufweist, der mit elektrischen und/oder elektronischen Bauteilen (8, 10) in Verbindung steht.

5. Hydraulische Kraftfahrzeugbremsanlage nach Anspruch 1, **dadurch gekennzeichnet**, daß der Drucksensor (1) und die Druckmodulationsventile (3) mittels einer Selbstverstemmung (11) in parallelen Stufenbohrungen (12) des Gehäuses (2) befestigt sind.

## Claims

1. Hydraulic automotive vehicle brake system with brake slip control and automatic brake management for traction control and/or driving dynamics control, including a braking pressure generator which is hydraulically connectable to at least one wheel brake and a pressure fluid accumulator by way of pressure modulation valves (3), at least one pump which is connected with its suction side to the pressure fluid accumulator and with its pressure side to a pressure fluid conduit that extends from the braking pressure generator to the wheel brake, the pressure fluid conduit comprising the pressure modulation valves (3) and a pressure sensor (1) that is connected to the pressure fluid conduit between the braking pressure generator and the pressure modulation valves, the pressure sensor (1) being accommodated in a housing (2) which houses the pressure modulation valves (3), **characterized** in that a cover (4) is attached to the housing (2) and is arranged on the pressure modulation valves (3) and the pressure sensor (1), and in that the cover (4) includes a carrier plate (7) for the accommodation of electric and/or electronic components (8), the carrier plate providing a connection to the pressure sensor (1) by way of an electrical plug connection.

2. Hydraulic automotive vehicle brake system as claimed in claim 1,
**characterized** in that a plug connector (5) is fitted between the cover (4) and the pressure sensor (1).

3. Hydraulic automotive vehicle brake system as claimed in claim 2,
**characterized** in that a profile seal (6) is interposed between the plug connector (5) and the pressure sensor (1).

4. Hydraulic automotive vehicle brake system as claimed in any one of the preceding claims,
**characterized** in that the pressure sensor (1) includes in a sensor housing a preferably capacitive transducer (9) which is connected to electric and/or electronic components (8, 10).

5. Hydraulic automotive vehicle brake system as claimed in claim 1,
**characterized** in that the pressure sensor (1) and the pressure modulation valves (3) are attached in parallel stepped bores (12) of the housing (2) by way of a self-caulking engagement (11).

## Revendications

1. Système hydraulique de freinage de véhicule automobile à régulation de glissement de freinage et intervention automatique des freins pour la régulation de traction et/ou la régulation de comportement dynamique de conduite, comprenant un générateur de pression de frein, qui est raccordable hydrauliquement à au moins un frein de roue et un réservoir d'agent de pression par l'intermédiaire de valves de modulation de pression (3), et au moins une pompe qui communique par son côté d'aspiration avec le réservoir d'agent de pression et par son côté de refoulement avec un trajet d'agent de pression qui mène du générateur de pression de frein au frein de roue et qui comprend les valves de modulation de pression (3) et un capteur de pression (1) raccordé au trajet d'agent de pression entre le générateur de pression de frein et les valves de modulation de pression, le capteur de pression (1) étant disposé dans un boîtier (2) qui sert à loger les valves de modulation de pression (3), caractérisé en ce qu'il est prévu, fixé sur le boîtier (2), un couvercle (4) qui est disposé par-dessus les valves de modulation de pression (3) et le capteur de pression (1) et en ce que, dans le couvercle (4), il est prévu une plaque de support (7) qui sert à recevoir des composants électriques et/ou électroniques (8) et qui réalise une liaison avec le capteur de pression (1) au moyen d'une connexion électrique par enfichage.

2. Système hydraulique de freinage de véhicule automobile suivant la revendication 1, caractérisé en ce qu'un connecteur à enfichage (5) est monté entre le couvercle (4) et le capteur de pression (1).

3. Système hydraulique de freinage de véhicule automobile suivant la revendication 2, caractérisé en ce qu'une garniture d'étanchéité (6) de forme profilée est prévue entre le connecteur à enfichage (5) et le capteur de pression (1).

4. Système hydraulique de freinage de véhicule automobile suivant l'une des revendications précédentes, caractérisé en ce que le capteur de pression (1) comprend, dans un boîtier de capteur, un transducteur (9) de préférence capacitif qui est relié à des composants électriques et/ou électroniques (8, 10).

5. Système hydraulique de freinage de véhicule automobile suivant la revendication 1, caractérisé en ce que le capteur de pression (1) et les valves de modulation de pression (3) sont fixées au moyen d'un autosertissage (11) dans des alésages étagés (12) parallèles du boîtier (2).
